# EUROPEAN PATENT SPECIFICATION

(11) **EP 3 125 380 B1**
(45) Date of publication and mention of the grant of the patent: **04.01.2023**
(21) Application number: 15768604.9
(22) Date of filing: 26.03.2015
(51) Int. Cl.: H02B 1/36, H02B 11/127, H02B 11/133

(54) **SAFETY DEVICE FOR LOCKING AND ACTUATING ELECTRICAL CONNECTORS ARRANGED IN A WITHDRAWABLE MCC DRAWER**
SICHERHEITSVORRICHTUNG ZUR VERRIEGELUNG UND BETÄTIGUNG VON IN EINEM RÜCKZIEHBAREN MCC-SCHUBFACH ANGEORDNETEN ELEKTRISCHEN STECKVERBINDERN
DISPOSITIF DE SÉCURITÉ POUR BLOCAGE ET ACTIONNEMENT DE CONNECTEURS ÉLECTRIQUES DISPOSÉS DANS UN TIROIR EXTRACTIBLE POUR CCM

(30) Priority: 28.03.2014 BR 1475623
(43) Date of publication of application: 01.02.2017
(73) Proprietor: Melquisedec, Francisquini, CEP: 06706-060 Cotia - SP (BR)
(72) Inventor: Melquisedec, Francisquini, CEP: 06706-060 Cotia - SP (BR)
(74) Representative: Michalski Hüttermann & Partner Patentanwälte mbB
(86) International application number: PCT/BR2015/000043
(87) International publication number: WO 2015/143521

(56) References cited:
- EP-A1- 1 227 557
- WO-A1-2008/122533
- BR-A- 0 306 929
- BR-A2- PI1 003 845
- BR-U- MU8 402 713
- BR-U2- MU8 900 420
- CN-Y- 2 406 397
- CN-Y- 2 408 598
- JP-A- 2012 060 806
- KR-B1- 100 831 290

## Description

### TECHNICAL FIELD

The present specification is related to a device notably developed to promote more security and better efficiency in its use, i.e., to operate in the locking and actuation of electrical connectors positioned in extractable drawers for MCC cabinets, thereby setting a safety device capable of connecting or disconnecting the internal connectors, both main and test connectors, provided in the extractable drawer for MCC cabinet, said procedure is executed mechanically through an assembly of elements that interconnect two thin laminar plates, these in turn, interconnected to each other, positioned inferiorly to the body of the drawer and with conformations corresponding to promote a perfect fit.

The safety device for locking and actuation of electrical connectors arranged in extractable drawer for a MCC cabinet, is particularly belonging to the field of safety devices for the actuation and/or locking of electrical equipment, said device of external operation with the door closed, promotes protection to operators of extractable drawers in MCC cabinets.

### PRIOR ART

As known by the professionals of the industry and commerce of electrical equipment, particularly electrical cabinets of MCC type (Motor Control Center), the referred MCC cabinets configure a handling and loading control system, especially of electrical motors of low or middle voltage.

The MCC cabinets are currently divided into areas that accommodate equipment for protection, sectioning and handling of loads, which present important function in the distribution systems of electric power in commercial and industrial units. Exactly where the cables from the loads are connected.

Although most of the industrial loads are formed by motors, reason of the name MCC (Motor Control Center), the term "loads" is quite general and can mean any equipment that consumes electrical energy, such as greenhouses, resistors and other correlated equipment, being its use intended to industrial installations presenting a plurality of loads that must be commanded, in which a maximum continuity of operation must be assured, and where the access of unskilled personnel is necessary, or also, in which is required a high level of safety for operators and maintenance personnel.

The MCC cabinets are made of metallic material, self-sustained, simplified or armored, which may be of TTA-type (Totally Tested Assembly), or PTTA-type (Partially Totally Tested Assembly).

In the TTA concept, the performance is assured by tests carried out individually in the plurality of components (bus, inputs, outputs, feeders, motor starters, etc.) or in the complete assembly.

These tests have the purpose of ensuring the performance of the assembly and minimize the risks caused by errors of the projects.

On the other hand, in PTTA-type, only some components are assayed and tested.

Therefore, the referred cabinets are formed by drawers which can be fixed or extractable.

The extractable drawers are specific for a safer operation and faster maintenance, mostly in cases of replacements during the operation.

The MCC cabinets are designed with a high standardization index, facilitating the assembly, installation and maintenance, besides allowing expansions and interchangeability between drawers of the same MCC cabinet model and of the same dimensions and functions.

The MCC cabinets have functions of mechanical and electrical interlocking, protection against the touch of living parts, total interlocking of contactors, metal divisions which prevent arc propagation, besides of providing safety of personal, operation and maintenance.

At the beginning, the MCC cabinets were not compartmentalized, i.e., they were provided with a single mounting plate, where the protection and the handling assemblies of individual loads were mounted together in this same plate; this solution is known as a conventional electrical cabinet.

On the other hand, in the compartmentalized MCC cabinets, the safety and handling equipment of each individual load are mounted in isolated compartments inside of the same panel. This MCC cabinet can be fixed or extractable.

In the fixed MCC cabinet, particularly inside each compartment is mounted a fixed mounting plate, where the equipment for safety and handling of the start are positioned.

Meanwhile, in the extractable MCC cabinet, particularly inside each compartment is mounted a drawer, which can be removed from the panel without the assistance of tools, such as levers or cranks, a common means of extraction for a long period of time.

The equipment for safety and handling of the starts are mounted inside the drawers, minimizing the downtime, since in this way, is possible to quickly replace the drawers.

The MCC cabinets are essential assemblies for the production, and with the advancement of technology and the need for the monitoring and the controlling of production, the use of networks is a solution that enables to reduce the downtime from hours to minutes, with a better and more complete diagnostics, by means of supervisory systems which locate accurately the problematic points during the production process, making it possible to know in what and where intervene and correct.

The prior art provides some models of extractable drawers for MCC cabinets, wherein each one is provided with a means other than extraction and reinsertion in the MCC cabinet, in addition to provide a handling, locking and actuation means of the electrical connectors.

After a brief search in the world patent banks, several documents of important relevance were found, among which the PI 0700143-6 filed on 04/01/2007, under the title, "SLIDING CONNECTION DEVICE OF EXTRACTABLE DRAWER IN ELECTRICAL PANEL", which refers to a sliding connection device for connecting an extractable drawer to a busbar of main power of an electrical panel, comprising a section fixed to the drawer and a sliding section associated to said fixed section. The fixed section is provided with terminals to which the power cables are connected and the sliding section is provided with electrical contacts for connecting to the power busbar, and that between said fixed section and said sliding section is arranged at least one movement course in the form of a groove and at least one intermediate contact performing the physical and electrical connection between said sections.

Thus, the device is capable of moving itself for coupling or uncoupling to the power busbar in such a way that only the sliding section performs this movement, while the fixed section and the power cables associated to it, remain immovable.

Further documents are described below, namely, DE102008046881, DE19504474 and FR2126117.

The document DE102008046881, filed on 18/03/2010, provides a module that has a locking unit and a contact switch unit with multiple contact switches, where the contact switches are operated by the locking unit, and where the locking unit and the contact switches are arranged in upper housings or on a housing carrier.

Two actuation components in the form of key holders are provided in the locking unit, being the module movable between a separating position and an operating position by the actuation components.

The contact switches are in contact with the busbars in the operating position.

The second document, DE19509474, filed on 19/09/1996, discloses a switching device that provides a number of shelves for holding busbars coupled to the drawers, wherein for each busbar there are contact sliders, and each of these has a rigid contact rail.

There is still a mechanism to bring the rack into contact or withdraw it, and the contact sliders and rails are on the back side of the rack.

All the contacts of one rack are operated by the same mechanism, positioned on the front side of the rack.

The contact sliders have grooves perpendiculars to the sliding direction in which a comb-like coupling element is positioned, joining to the operating mechanism and, finally, each contact slider has two spring contacts, between which the busbar fits.

The third document, FR2126117, filed on 26/02/1971, relates to the embodiment of a mechanical coupling system for a locking position of two objects, and afterwards its release or disengagement, being this effect possible due to the use of two appropriate levers, where its commands can be simultaneous or not, and may be even used in junction of connectors, drawers, cabinets, power modules, etc.

The prior art further discloses the document AU2002252966, filed on 17/02/2005, which refers to a low voltage switchgear comprising an appliance module for receiving appliances according to the switching, control and protection technology. A locking bar comprising laterally projecting bolts is arranged in a housing of the appliance module, perpendicularly in relation to the direction of displacement.

Positioning cranks are arranged on lateral edges of the bottom of a section, the bolts cooperating with said positioning cranks in order to lock the appliance module in an operating, separating and test position.

A lifting gear is used to lift the locking rod in its working position, said lifting gear being actuated by means of a control unit which is arranged on an operating face.

The test position is held if a separation auxiliary contact is locked in the separation position of the appliance module.

CN 2 406 397 Y describes a connector controlling technique for a low-voltage distribution cabinet, particularly a drawer of a low voltage distribution cabinet, which comprises connectors.

CN 2 408 598 Y describes a connector control technique for low-voltage power distributing cabinets, particularly an operation mechanism for driving a primary connector and a secondary connector to move.

WO 2008/122533 A1 describes a module rack for an electric control panel, having a module rack housing comprising a base plate, a front side, and a rear wall.

Another document is US7791862, filed on 19/06/2008 and refers to an electrical switching system comprising a housing and components which are arranged therein and which are embodied as a control and/or measuring unit.

Said components are arranged in modular-type drawers.

A base module comprises at least one module support profile, in addition to lateral walls and front sided insertion elements.

One front wall of the base module, preferably the front side thereof, is formed by a control unit and the opposite front wall of the measuring unit, and the dimensions of the control and measuring unit are adapted to the size of the module.

Nevertheless, the most modern and used type of extractable drawer in the prior art is still to be mentioned herein, and is configured by a type of extractable drawer equipped with a safety system which has two actuation and locking keys of the assemblies, being one smaller that actuate the connectors of the test command and one larger that actuate the connectors to the power input of the system, i.e., coupling the connectors to the busbars, which actuates all the equipment connected therein.

First, it is worth mentioning that in this type of extractable drawer, the procedure that the operator uses to verify the functioning conditions of the system takes place from the actuation or rotation of the lower command, which is conformed by a special short key, that mechanically actuate the test device of the system.

After verifying the conditions of the equipment that will be actuated, when the operator rotates the special short key in reverse, the test device of the system will be de-energized.

Thus, after withdrawing the special short key, an elongated key is inserted in the same hole, actuating also by rotation, the equipment, being this actuation executed through a mechanical device provided with a plurality of rods, turnstiles and joints, which interconnects the actuating means of the equipment, pressing the clutches of the extractable drawer, connecting them to the busbars that energize the equipment.

The device described above is what there is of most modern used by the consumer public. However, the referred device also presents some inconvenients among which the need of using two keys for the actuation of the test and operation of the equipment.

Another important inconvenient is due to the number of components used for the full operation of the device, where the fatigue or failure of any of the component elements of this device, may cause the malfunction or still the total locking of the aforementioned safety device.

### BRIEF DESCRIPTION OF THE INVENTION

The invention is defined by the features of the independent claim. Preferred embodiments are defined by the features of the dependent claims.

Thinking about the existing inconvenients and in order to promote more safety and protection for the operators of MCC cabinets, the simplification in the use and reduction of the manufacturing costs, the inventor, after an extensive research has created and developed this "SAFETY DEVICE FOR THE LOCKING AND ACTUATION OF ELECTRICAL CONNECTORS PROVIDED IN EXTRACTABLE DRAWER FOR MCC CABINET", which should be positioned with total distinction among its similars and be customized before the consumer market by the fact of presenting a device developed to promote more safety in its use, i.e., to actuate in the locking and actuation of electrical connectors positioned in the extractable drawers for MCC cabinets, thereby setting a safety device capable of connecting or disconnecting the internal connectors along with their respective busbars, both the main connector and the test connector, arranged in an extractable drawer for MCC cabinet, said procedure is executed mechanically through an assembly of elements that interconnects two thin laminar plates, these in turn are interconnected to each other, positioned inferiorly and of conformations corresponding to promote a perfect fit.

The mechanical actuation of the elements of this assembly is performed externally with the door closed, from the actuation of a main key which actuates a pendulum, which moves an assembly of gears suitably arranged in the extractable drawer for MCC cabinet, which in turn moves the lower laminar plates, connecting the test device and posteriorly the connectors, wherein said connectors, when in contact with their corresponding busbars, energize the equipment in which they are connected.

### BRIEF DESCRIPTION OF THE DRAWINGS

The subject matter of this invention will become fully clear in its technical aspects as from the detailed description that will be performed based on the figures listed below, wherein:

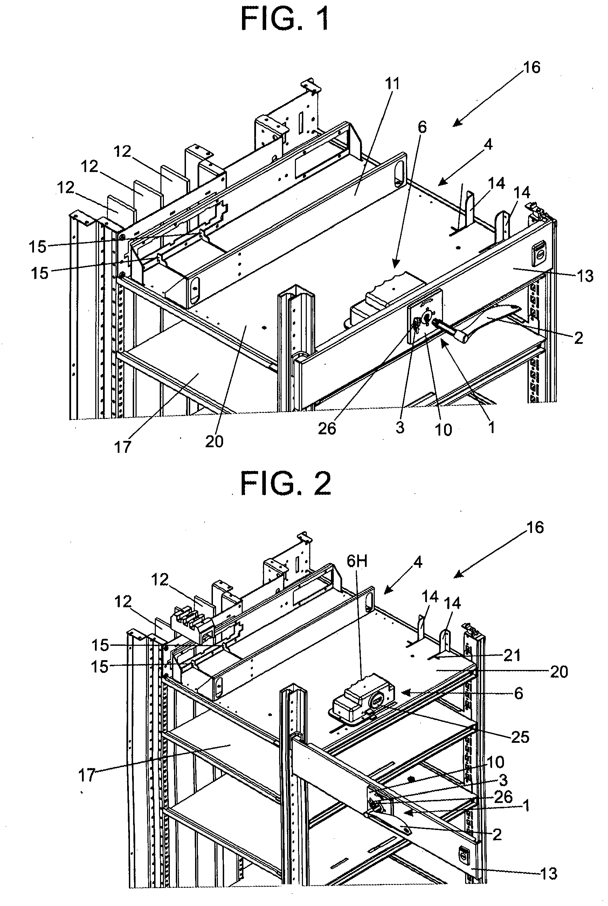

- Figure 1 shows a top view, in perspective, of an extractable drawer for MCC cabinet, illustrating the door of the extractable drawer, the safety device, the gear assembly and the movement transmission that interconnect the connectors and the busbars;
- Figure 2 shows a top view, in perspective of an extractable drawer for MCC cabinet, illustrating the door of the extractable drawer opened, showing the autonomous safety device coupled to the door, the gear assembly and the movement transmission elements that interconnect the connectors and the busbars;

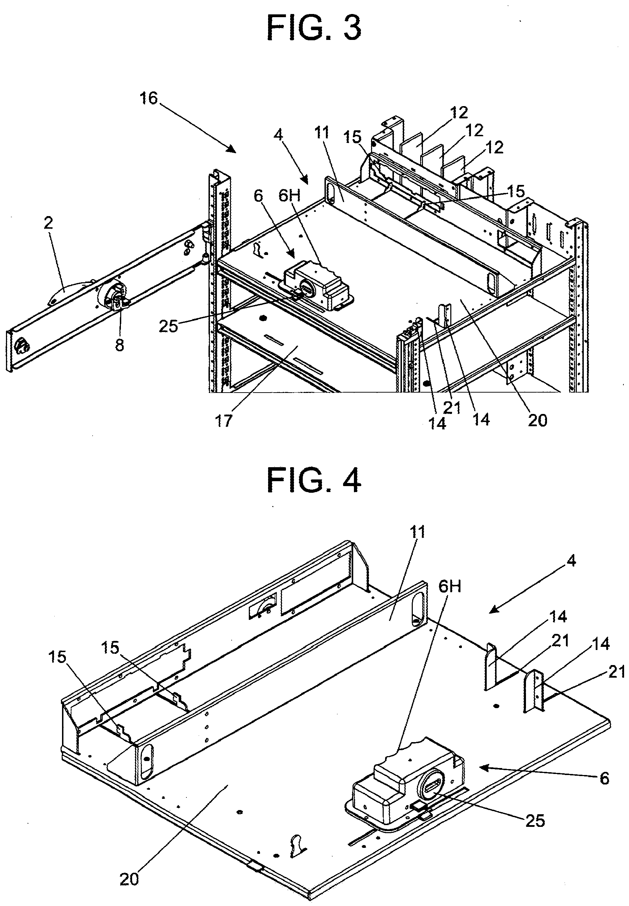

- Figure 3 shows a top view, in perspective, of an extractable drawer for MCC cabinet, illustrating the door of the drawer opened, showing the back face of the autonomous safety device coupled to the door, the gear assembly and the orthogonal laminar tabs of the movement transmission elements that interconnect the connectors and the busbars;
- Figure 4 shows a top view, in perspective, of an extractable drawer for MCC cabinet, illustrating the gear assembly and the orthogonal laminar tabs of the movement transmission elements that interconnect the connectors and the busbars;

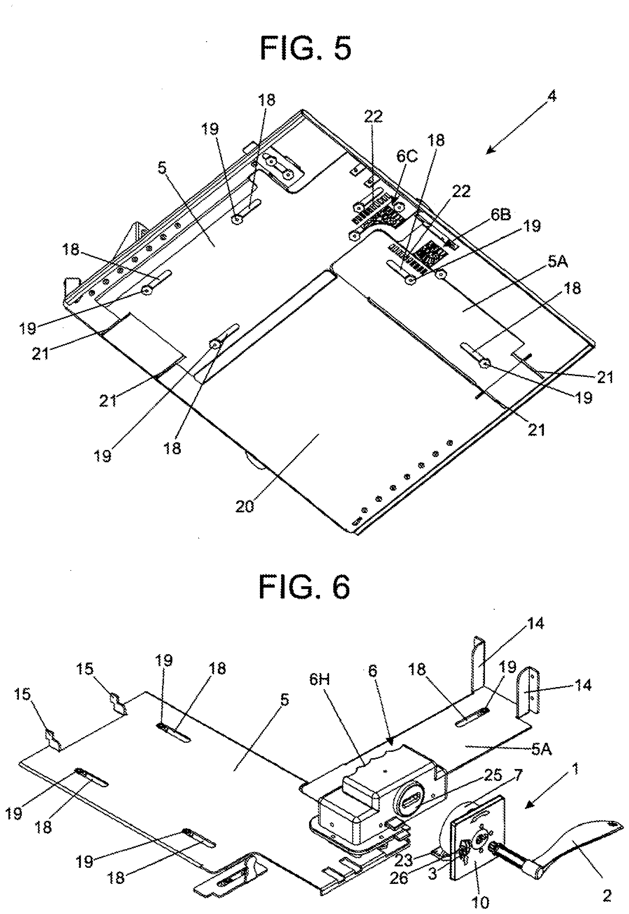

- Figure 5 shows a bottom view, in perspective, of an extractable drawer for MCC cabinet, illustrating the gear assembly and the movement transmission elements that interconnect the connectors and the busbars, mechanically protected;
- Figure 6 shows a top view, in perspective, of the safety device, the gear assembly and the laminar plates provided with orthogonal tabs of movement transmission that interconnect the connectors and the busbars;

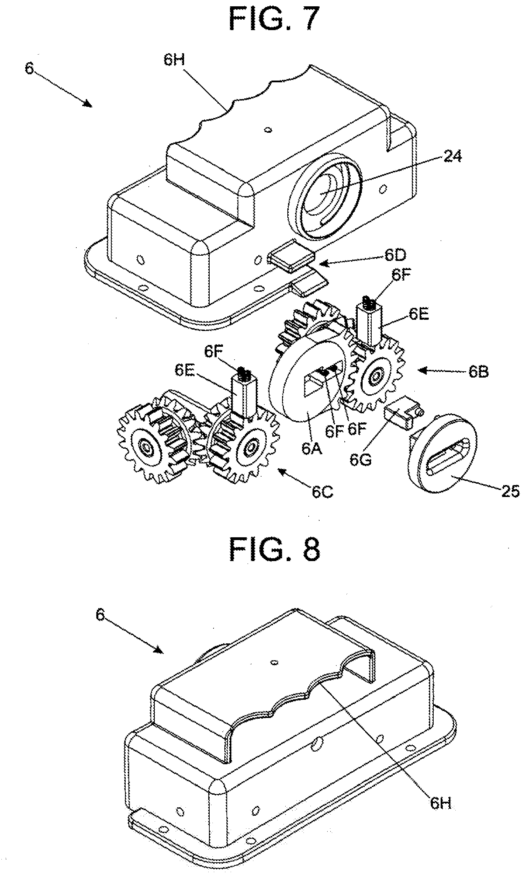

- Figure 7 shows a front view, in perspective and exploded, of the gear gear assembly, showing each internal set of gears;
- Figure 8 shows a rear top view, in perspective, of the gear assembly;

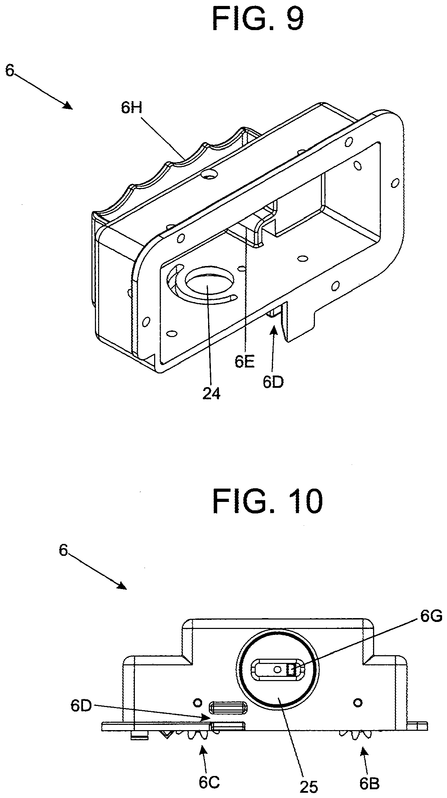

- Figure 9 shows a bottom view, in perspective, of the gear assembly;
- Figure 10 shows a front view of the gear assembly;

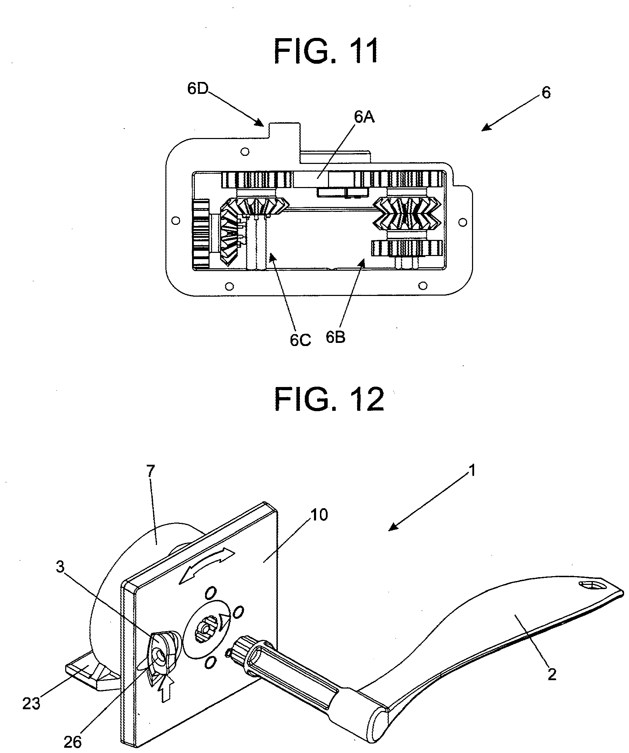

- Figure 11 shows a bottom view, in perspective, of the gear assembly;
- Figure 12 shows a perspective view of the door lock assembly of the extractable drawer for MCC cabinet; and

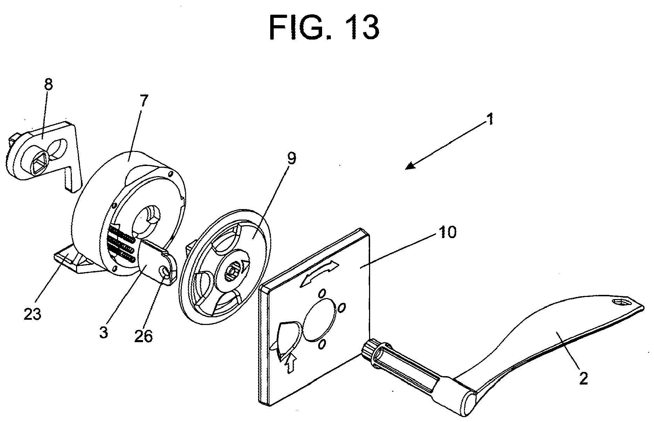

- Figure 13 shows a perspective exploded view of the door lock assembly of the extractable drawer for MCC cabinet.

### DETAILED DESCRIPTION OF THE INVENTION

In accordance with the aforementioned illustrated figures, the present invention "SAFETY DEVICE FOR THE LOCKING AND ACTUATION OF ELECTRICAL CONNECTORS PROVIDED IN EXTRACTABLE DRAWER FOR MCC CABINET" refers more particularly to a safety device 1 notably developed to promote the connection and disconnection of the internal connectors with the corresponding busbars 12, both the main power connector that actuates the main equipment and the test connector are arranged in the extractable drawer 4 for MCC cabinet 16 of multiple compartments 17, with mechanical movement of the elements provided in the safety device 1, which takes place externally with the door closed, from the movement of a special actuation key 2 that is provided with an autonomous safety device which in turn actuates a pendulum, that moves the gear assembly 6 suitably arranged on the front section of the extractable drawer 4 for MCC cabinet 16, immediately behind the safety device 1, wherein said safety device 1 actuates the gear assembly 6, which in turn move the lower laminar plates 5 and 5A actuating the test connector and subsequently the main connectors, being that the main connectors, when in contact with their corresponding busbars 12, energize the equipment in which they are connected.

The laminar plates 5 and 5A are strategically positioned on the lower face of the extractable drawer4 for MCC cabinet 16 and are provided with a plurality of small oblong cutouts 18 wherein small guide pins 19 are fitted and arranged in the base 20 of the extractable drawer 4, which is formed in a single piece, said guide pins 19 delimit the movement of these plates 5 and 5A.

Furthermore, said plates 5 and 5A are provided with at least two small laminar tabs 14, which are orthogonal extensions of the plates 5 and 5A themselves, being these orthogonal to its plane and inserted in guide cutouts 21, pressing the connectors provided on the extractable drawer 4 towards their corresponding busbars 12.

The laminar plates 5 and 5A are provided with also a plurality of small rectangular cutouts 22 aligned with each other and passible of receiving the gear teeth provided in the gear assembly 6, by moving the laminar plates 5 and 5A to connect or disconnect the connectors of the busbars 12.

As stated above, the procedure is performed mechanically through at least one gear assembly 6 which interconnect the safety device 1 with the thin and inferior laminar plates 5 and 5A, these in turn are interconnected to each other, being positioned inferiorly and of corresponding conformations, the larger laminar plate 5moves the connectors toward the corresponding busbars 12, energizing therefore the entire system and, in addition, a smaller laminar plate 5A is provided corresponding to the first larger laminar plate 5, being said laminar plate 5A actuated before the larger laminar plate 5, so that a functioning test is performed in order to release the operation of the main equipment for use.

The test device is actuated on the first movement of the actuation key 2 of the extractable drawer 4, concomitant with pressing the locking device 3, without which the actuation key 2 does not rotates, connecting the test device of said extractable drawer 4 and verifying the proper functioning of the system as a whole.

Subsequent to the actuation of this test device, through a new movement of the actuation key 2, along with a new actuation of the locking device 3, it will be possible to actuate the main connectors, energizing all the equipment connected therein.

The same reverse procedure occurs at the system shutdown, when the actuation key 2 should move conversely.

Thus, the referred safety device 1 allows the actuation of the system only in a secure environment, i.e., the actuation of the main equipment occurs only sequentially through an actuation key 2, wherein the test device is actuated first by means of the special actuation key 2, which has specific conformation, in order to actuate the main equipment posteriorly, so that in the event of any malfunction found in the equipment, whether electrical or mechanical, the first connector designed for testing, is passible to receiving an electric charge substantially lower than the main power, minimizing or even eliminating inconvenients arising from malfunctions in the electrical system or in the equipment itself.

The connector of test of the system functioning is released, primarily through the actuation key 2 that actuates the connectors of the test command and, then, the entire system is released through the same actuation key 2, actuating the main connectors in the busbars 12 of the electrical system of the equipment coupled to the MCC cabinet 16, turning on all the equipment, being that these two steps, the actuation of the test device and the actuation of the main connectors, occur in the front of the extractable drawer 4 locked in the "closed" position.

The unlocking of the extractable drawer 4 occurs in the actuation of the test command and, posteriorly and in the sequence, the main connection command of the busbars 12 of the system is actuated and, at this moment, the latch locks the front of the extractable drawer 4.

Thus, to better illustrate the functioning steps of this system, following is a table showing the moving and connection steps of the busbars 12 of the extractable drawer 4.

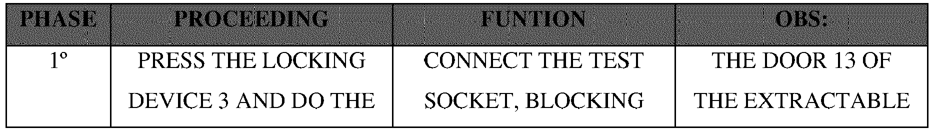

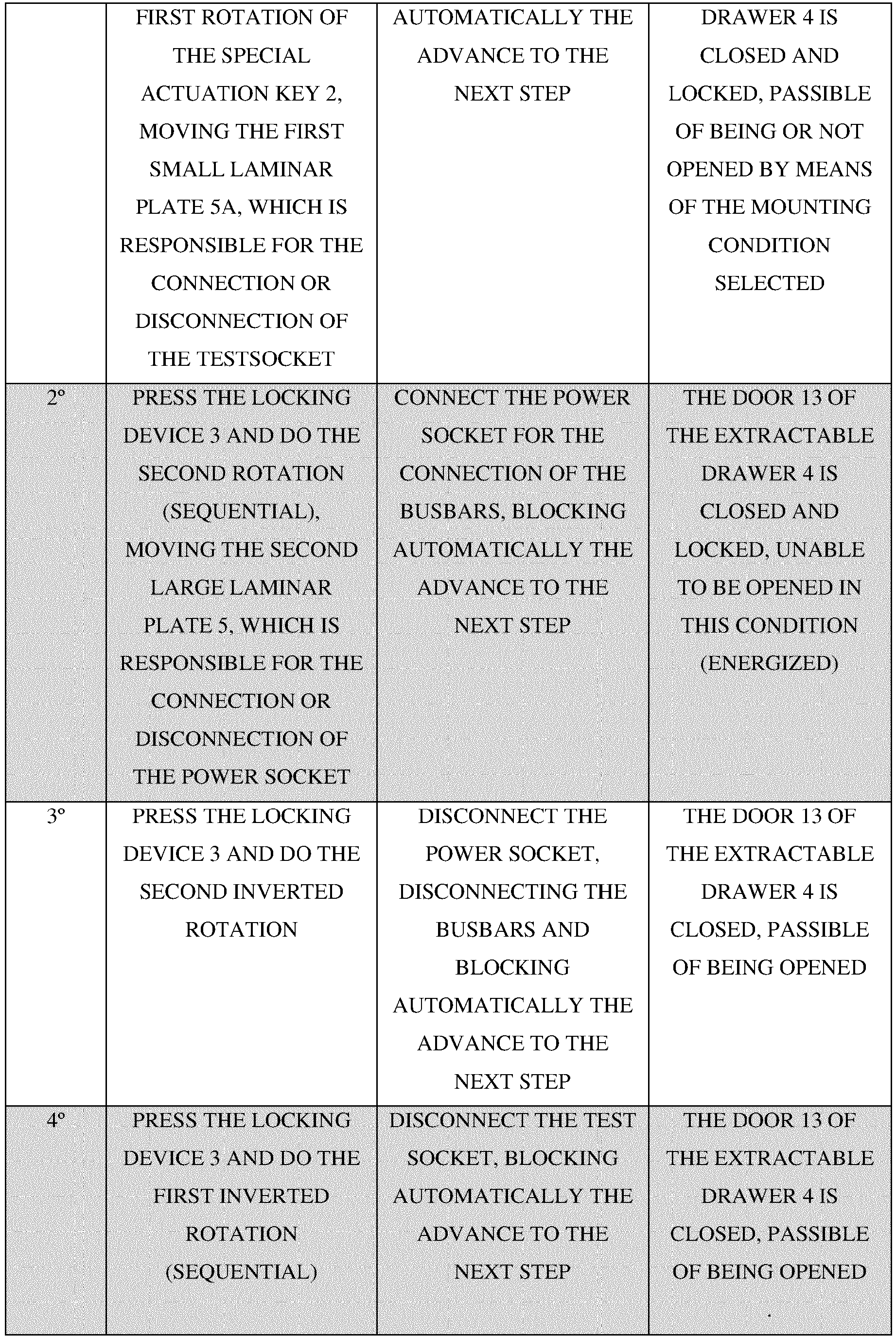

More specifically, the safety device 1 for the locking and actuation of the electrical connectors arranged in an extractable drawer 4 for MCC cabinet 16, presents a degree of protection IP40 to IP55 and their compartmentalization forms up to 4B, in accordance with the NR10 requirements.

The sealing and locking of the extractable drawer 4 through a padlock or other equivalent locking means are also possible when the compartment is empty, due to the operating system of the extractable drawer 4 coupled to the door 13.

The positioner presents a specific encoding and has been developed for different types of extractable drawers 4.

On the other hand, the modular socket of command and the lateral or back network provide flexibility to the use of different types of connectors, such as PROFIBUS, ETHERNET, or output of power up to 100A, etc.

The working mechanism of the extractable drawer 4 occurs through oriented gears and operates sequentially through mechanical interlocks.

In this way, in order to access the interior of the extractable drawer 4, to be possible to turn on or off the equipment connected to the MCC cabinet 16, to perform maintenance, among others, first, the actuation key 2 is inserted, positioning the system in the test mode, turning on the test command which can occur with the door 13 opened or closed or still, optionally only with the door 13 closed.

Subsequently, the actuation key 2 of the main equipment is actuated, remembering that the actuation of the system through the actuation key 2 only occurs if the test command is connected and the door 13 of the extractable drawer 4 is closed. Thus, there will be no movement of the connecting cables and the door 13 will be automatically locked.

Then, the actuation key 2 is returned to the test position, turning off the power input, at this stage necessarily with the door 13 closed, releasing the locks of the door 13 and of the test command.

Finally, it returns to the "disconnected" position by turning off the command, said operation is possible only and exclusively if the power input is disconnected.

The extractable drawer 4 also provides a mounting plate of components 11, positioned transversally.

The power transmission assembly and the mechanical lock assembly are constituted by a safety device 1, a gear assembly 6 and finally by an assembly of laminar plates 5 and 5A provided with elements that interconnect to the connectors for the actuation/locking of the system with the busbars 12.

The safety device 1 is positioned in the door 13 of the extractable drawer 4 and is formed by a frame 10 of fixing and finishing of the safety device 1, opposite to which is positioned a drive bushing 9, this in turn, is fitted axially in a body 7 of the safety device 1, which provides a guide tab 23 and, fitted in the back section of this body 7 is positioned a coupling tab 8 of the drawer and the safety lock actuation.

On the other hand, the gear assembly 6 interconnected to the lock assembly, presents internally a central pendulous element 6A flanked by at least one gear 6B, 6C, passible of actuating the connection point for the test device, or still, actuating the connection point of the power input 15 or both.

Internal additional elements of the gear assembly 6 are spring elements 6F that permit the full functioning of all elements, in a precisely and adjusted way, being that each one of the gear assembly 6presents a housing 6E in which these spring elements 6F are positioned.

The back face of the gear assembly 6 presents an ergonomic section 6Hnotably designed to receive the fingers of the operator, allowing the manual movement of the extractable drawer 4 when required.

The front face of the gear assembly 6 presents two small guide tabs 6D parallel to each other, positioned vertically, holding between them an interstice of housing for a third tab called guide tab 23, provided in the back section of the body 7 of the safety device 1, this being positioned in the back section of the lock assembly and fitting between the tabs 6D of the gear assembly 6, being said device designed to maintaining interlocked the whole safety device 1 and gear assembly 6.

Furthermore, the front face of the gear assembly 6 presents a central hole 24, which houses a switch 25 that receives the end of a special actuation key 2 for the actuation of the system, wherein said actuation key 2 is provided with a small salience that presses a small button 6G coupled to said switch 25, which when pressed by the salience in the end of the special actuation key 2, allows to rotate the referred actuation key 2, in conjunction with the pressing of the locking device 3 or the external button of safety, which is positioned next to the special actuation key 2, actuating the test device and then, by pressing again the locking device 3, allows to rotate the actuation key 2 to actuate the assembly of the power input 15 of the equipment where the extractable drawer 4 of the MCC cabinet is connected.

The locking device 3 presents a hole 26, which is designed to receive a safety padlock, the said padlock locks the entire assembly and prevents from being manipulated without permission.

Although detailed the invention, it is important to understand that the same does not limit its application to the details and steps described herein. The invention is capable of other embodiments and of being practiced or executed in a variety of ways. It should be understood that the terminology employed herein is for purpose of description and not of limitation.

## Claims

1. Motor Control Center, MCC, cabinet (16) comprising
an extractable drawer (4),
a door (13) for the extractable drawer (4),
a main power connector and a test connector arranged in the extractable drawer (4) as electrical connectors,
a safety device (1) coupled to the door (13), configured for actuating by means of an actuation key (2) with pressing a locking device (3) and configured for locking and actuation of the main power and test connectors provided in the extractable drawer (4),
a gear assembly (6), and
at least two laminar plates (5, 5A); whereby
the actuation key (2) is connectable to the gear assembly (6), which is arranged in the frontal section of the extractable drawer (4) behind the safety device (1), the gear assembly (6) is connected to the lower laminar plates (5, 5A), which are connected to the power and test connectors;
the laminar plates (5, 5A) are positioned on the lower face of the extractable drawer (4) for MCC cabinet (16) and are provided with a plurality of oblong cutouts (18) wherein guide pins (19) are fitted and arranged in the base (20) of the extractable drawer (4), which is formed in a single piece;
said laminar plates (5, 5A) are provided with at least two laminar tabs (14, 15) which are orthogonal extensions of the plates (5, 5A), orthogonal to its plane and inserted in guide cutouts (21);
the laminar plates (5, 5A) are provided with a plurality of rectangular cutouts (22) aligned with each other and configured to receive the gear teeth provided in the gear assembly (6), said laminar tabs (14, 15) being connection points for the test connector and the main power connector respectively;
the gear assembly (6) presents internally, a central pendulous element (6A) flanked by at least one set of gears (6b, 6c), configured to actuate the connection point (14) for the test connector and the connection point (15) for the main power connector;
the internal additional elements of the gear assembly (6) are constituted by spring elements (6F);
the gear assembly (6) presents a housing (6E) in which these spring elements (6F) are positioned;
the back face of the gear assembly (6) presents an ergonomic section (6H) and the front face of the gear assembly (6) presents two small guide tabs (6D) parallel to each other, positioned vertically, holding between them an interstice of housing for a third tab called guide tab (23), provided in the back section of a body (7) of the safety device (1), this being positioned in the back section of the safety device (1) and fitting between the tabs (6D) of the gear assembly (6); and
the front face of the gear assembly (6) presents a central hole (24), which houses a switch (25) that receives a coupling tab (8), which is connectable with the end of the actuation key (2), for the actuation of the electrical connectors, wherein said actuation key (2) is provided with a small salience that presses a button (6) coupled to said switch (25), which when pressed by the salience in the end of the actuation key (2), in conjunction with the pressing of the locking device (3), allows to rotate the actuation key (2) to actuate the test connector and then, by pressing again the locking device (3), allows to rotate the actuation key (2) to actuate the main power connector of the equipment where the extractable drawer (4) of the MCC cabinet (16) is connected.

2. MCC cabinet (16) according to the previous claim, whereby
the safety device (1) is configured for actuating in a first movement of the actuation key (2) of the extractable drawer (4) to actuate the test connector, concomitant with pressing the locking device (3), such that the main connectors are actuated in a second movement of the actuation key (2) of the electrical connectors along with a new actuation of the locking device (3).

3. MCC cabinet (16) according to any of the previous claims, whereby the safety device (1) is configured that the two steps, the actuation of the test connector and the actuation of the main connectors, occur with the door (13) of the extractable drawer (4) being locked in the closed position such that the unlocking of the door (13) of the extractable drawer (4) occurs in the actuation of the test connector, and/or that the door (13) of the extractable drawer (4) locks when the main power connector is actuated.

4. MCC cabinet (16) according to any of the previous claims, whereby the safety device (1) is configured that in order to access the interior of the extractable drawer (4) and to be possible to turn on or off equipment connected to the MCC cabinet (16), to perform maintenance, among others, first, the actuation key (2) is inserted, the electrical connectors are positioned in the test mode by turning on the test connector which can occur only with the door closed.

5. MCC cabinet (16), according to any of the previous claims, whereby the safety device (1) is configured that
the actuation of the main power connector through the actuation key (2) only occurs if the test connector is connected and the door (13) of the extractable drawer (4) is closed, that
when the actuation key (2) returns from the actuation position of the main power connector to the test position, the door is released, and/or that
the return to the disconnected position, occurs by turning off the test connector of the test position, being this operation possible only and exclusively if the power input is disconnected.

6. MCC cabinet (16) according to any of the previous claims, whereby
the safety device (1) is positioned in the door (13) of the extractable drawer (4) and is formed by a frame (10) fixing the safety device (1), opposite to which is positioned a drive bushing (9), this in turn, is fitted axially in the body (7) of the safety device (1), which provides a guide tab (23) and, fitted in the back section of this body (7) is positioned the coupling tab (8) of the drawer (4) and the safety device (1).

7. MCC cabinet (16) according to any of the previous claims, whereby
the safety device (1) for the locking and actuation of the electrical connectors presents a degree of protection IP40 to IP55 and their compartmentalization forms up to (4B), in accordance with the NR10 requirements, and/or
the extractable drawer (4) is configured that the sealing and locking of the extractable drawer (4) is also possible through a padlock or other equivalent locking means.

8. MCC cabinet (16) according to any of the previous claims, whereby
the locking device (3) presents a hole (26) which is a receptor of the safety padlock, and/or that
the safety device (1) is configured that by pressing the locking device (3) and doing the first rotation of the actuation key (2), the first small laminar plate (5A), responsible for the actuation or locking of the test socket, is moved; the door (13) of the extractable drawer (4) remains closed and locked.

## Patentansprüche

1. Motor-Control-Center-, MCC, Schrank (16) mit:
einer ausziehbaren Schublade (4);
einer Tür (13) für die ausziehbare Schublade (4);
einem Hauptstromverbinder und einem Prüfverbinder, die in der ausziehbaren Schublade (4) als elektrische Verbinder angeordnet sind;
einer Sicherheitsvorrichtung (1), die mit der Tür (13) verbunden und dafür konfiguriert ist, mittels eines Betätigungsschlüssels (2) durch Drücken einer Verriegelungsvorrichtung (3) betätigt zu werden, und zum Verriegeln und Betätigen des Hauptstrom- und des Prüfverbinders konfiguriert ist, die in der ausziehbaren Schublade (4) vorgesehen sind;
einer Zahnradanordnung (6); und
mindestens zwei flächigen Platten (5, 5A), wobei
der Betätigungsschlüssel (2) mit der Zahnradanordnung (6) verbindbar ist, die im vorderen Bereich der ausziehbaren Schublade (4) hinter der Sicherheitsvorrichtung (1) angeordnet ist, wobei die Zahnradanordnung (6) mit den unteren flächigen Platten (5, 5A) verbunden ist, die mit den Hauptstrom- und mit dem Prüfverbinder verbunden sind,
die flächigen Platten (5, 5A) auf der unteren Fläche der ausziehbaren Schublade (4) für den MCC-Schrank (16) angeordnet und mit einer Mehrzahl von länglichen Ausschnitten (18) versehen sind, in die Führungsstifte (19) eingepasst sind, die im Boden (20) der ausziehbaren Schublade (4) angeordnet sind, die als ein einziges Teil ausgebildet ist,
die flächigen Platten (5, 5A) mindestens zwei flächige Laschen (14, 15) aufweisen, die orthogonale Erweiterungen der Platten (5, 5A) sind, orthogonal zu ihrer Ebene angeordnet und in Führungsausschnitte (21) eingesetzt sind,
die flächigen Platten (5, 5A) eine Mehrzahl von rechteckigen Ausschnitten (22) aufweisen, die miteinander ausgerichtet und dafür konfiguriert sind, die in der Zahnradanordnung (6) vorgesehenen Zahnradzähne aufzunehmen, wobei die flächigen Laschen (14, 15) Verbindungspunkte für den Prüfverbinder bzw. den Hauptstromverbinder sind,
die Zahnradanordnung (6) im Inneren ein mittiges, pendelndes Element (6A) aufweist, das von mindestens einem Satz von Zahnrädern (6b, 6c) flankiert ist, die dafür konfiguriert sind, den Verbindungspunkt (14) für den Prüfverbinder und den Verbindungspunkt (15) für den Hauptstromverbinder zu betätigen,
die inneren Zusatzelemente der Zahnradanordnung (6) durch Federelemente (6F) gebildet werden,
die Zahnradanordnung (6) ein Gehäuse (6E) aufweist, in dem diese Federelemente (6F) angeordnet sind,
die Rückseite der Zahnradanordnung (6) einen ergonomischen Abschnitt (6H) aufweist und die Vorderseite der Zahnradanordnung (6) zwei kleine Führungslaschen (6D) aufweist, die sich parallel zueinander erstrecken, vertikal angeordnet sind und dazwischen einen Aufnahmeraum für eine dritte, als Führungslasche (23) bezeichnete Lasche halten, die im hinteren Abschnitt eines Körpers (7) der Sicherheitsvorrichtung (1) vorgesehen ist, wobei diese im hinteren Abschnitt der Sicherheitsvorrichtung (1) angeordnet und zwischen den Laschen (6D) der Zahnradanordnung (6) eingepasst ist, und
die Vorderseite der Zahnradanordnung (6) ein mittiges Loch (24) aufweist, das einen Schalter (25) aufnimmt, der eine Verbindungslasche (8) aufnimmt, die mit dem Ende des Betätigungsschlüssels (2) zum Betätigen der elektrischen Verbinder verbindbar ist, wobei der Betätigungsschlüssel (2) eine Ausprägung aufweist, die einen mit dem Schalter (25) verbundenen Knopf (6) drückt, der, wenn er durch die Ausprägung am Ende des Betätigungsschlüssels (2) gedrückt wird, in Verbindung mit dem Drücken der Verriegelungsvorrichtung (3) eine Drehbewegung des Betätigungsschlüssels (2) ermöglicht, um den Prüfverbinder zu betätigen, und dann, durch erneutes Drücken der Verriegelungsvorrichtung (3), eine Drehbewegung des Betätigungsschlüssels (2) ermöglicht, um den Hauptstromverbinder eines Geräts zu betätigen, mit dem die ausziehbare Schublade (4) des MCC-Schranks (16) verbunden ist.

2. MCC-Schrank (16) nach dem vorhergehenden Anspruch, wobei
die Sicherheitsvorrichtung (1) dafür konfiguriert ist, in einer ersten Bewegung des Betätigungsschlüssels (2) der ausziehbaren Schublade (4) betätigt zu werden, um den Prüfverbinder zu betätigen, während gleichzeitig die Verriegelungsvorrichtung (3) gedrückt wird, so dass der Hauptstromverbinder der elektrischen Verbinder in einer zweiten Bewegung des Betätigungsschlüssels (2) zusammen mit einer erneuten Betätigung der Verriegelungsvorrichtung (3) betätigt wird.

3. MCC-Schrank (16) nach einem der vorhergehenden Ansprüche, wobei die Sicherheitsvorrichtung (1) derart konfiguriert ist, dass die beiden Schritte, das Betätigen des Prüfverbinders und das Betätigen des Hauptstromverbinders, bei einer in der geschlossenen Position verriegelten Tür (13) der ausziehbaren Schublade (4) ausgeführt werden, so dass das Entriegeln der Tür (13) der ausziehbaren Schublade (4) beim Betätigen des Prüfverbinders erfolgt, und/oder dass die Tür (13) der ausziehbaren Schublade (4) beim Betätigen des Hauptstromverbinders verriegelt wird.

4. MCC-Schrank (16) nach einem der vorhergehenden Ansprüche, wobei die Sicherheitsvorrichtung (1) derart konfiguriert ist, dass, um auf das Innere der ausziehbaren Schublade (4) zugreifen zu können und um an den MCC-Schrank (16) angeschlossene Geräte ein- oder ausschalten zu können, um u.a. Wartungsarbeiten auszuführen, zunächst der Betätigungsschlüssel (2) eingesetzt wird und die elektrischen Verbinder durch Einschalten des Prüfverbinders in den Prüfmodus geschaltet werden, was nur bei geschlossener Tür erfolgen kann.

5. MCC-Schrank (16) nach einem der vorhergehenden Ansprüche, wobei die Sicherheitsvorrichtung (1) derart konfiguriert ist, dass
das Betätigen des Hauptstromverbinders durch den Betätigungsschlüssel (2) nur dann erfolgt, wenn der Prüfverbinder verbunden ist und die Tür (13) der ausziehbaren Schublade (4) geschlossen ist;
wenn der Betätigungsschlüssel (2) aus der Betätigungsposition des Hauptstromverbinders in die Prüfposition zurückkehrt, die Tür freigegeben wird; und/oder dass
ein Schaltvorgang in eine unterbrochene Position durch Ausschalten des Prüfverbinders erfolgt, wobei dieser Vorgang nur und ausschließlich dann möglich ist, wenn die Stromzufuhr unterbrochen ist.

6. MCC-Schrank (16) nach einem der vorhergehenden Ansprüche, wobei
die Sicherheitsvorrichtung (1) in der Tür (13) der ausziehbaren Schublade (4) angeordnet ist und durch einen Rahmen (10) gebildet wird, der die Sicherheitsvorrichtung (1) fixiert, der gegenüber eine Antriebsbuchse (9) angeordnet ist, die ihrerseits axial in den Körper (7) der Sicherheitsvorrichtung (1) eingepasst ist, der eine Führungslasche (23) bereitstellt, und wobei eingepasst im hinteren Bereich dieses Körpers (7) die Verbindungslasche (8) der Schublade (4) und der Sicherheitsvorrichtung (1) angeordnet ist.

7. MCC-Schrank (16) nach einem der vorhergehenden Ansprüche, wobei
die Sicherheitsvorrichtung (1) für die Verriegelung und Betätigung der elektrischen Verbinder einen Schutzgrad IP40 bis IP55 aufweist, und ihre Unterteilung hat die Form (4B) und entspricht den NR10-Anforderungen, und/oder
die ausziehbare Schublade (4) derart konfiguriert ist, dass die Abdichtung und Verriegelung der ausziehbaren Schublade (4) auch durch ein Vorhängeschloss oder eine andere äquivalente Verriegelungseinrichtung möglich ist.

8. MCC-Schrank (16) nach einem der vorhergehenden Ansprüche, wobei
die Verriegelungsvorrichtung (3) ein Loch (26) aufweist, das eine Aufnahme für das Sicherheitsvorhängeschloss ist, und/oder
die Sicherheitsvorrichtung (1) derart konfiguriert ist, dass durch Drücken der Verriegelungsvorrichtung(3) und Ausführen der ersten Drehbewegung des Betätigungsschlüssels (2) die erste flächige Platte (5A), die für das Betätigen oder Verriegeln des Prüfverbinders zuständig ist, bewegt wird, während die Tür (13) der ausziehbaren Schublade (4) geschlossen und verriegelt bleibt.

## Revendications

1. Armoire de centre de commande de moteur, CCM, (16) comprenant
un tiroir extractible (4),
une porte (13) pour le tiroir extractible (4),
un connecteur d'énergie principal et un connecteur de test disposés dans le tiroir extractible (4) servant de connecteurs électriques,
un dispositif de sécurité (1) couplé à la porte (13), permettant l'actionnement au moyen d'une clé d'actionnement (2) en pressant un dispositif de verrouillage (3) et conçu pour le verrouillage et l'actionnement des connecteurs d'énergie principal et de test mis en place dans le tiroir extractible (4),
un ensemble d'engrenages (6), et
au moins deux plaques lamellaires (5, 5A) ; ce par quoi
la clé d'actionnement (2) peut être connectée à l'ensemble d'engrenages (6) qui est disposé dans la partie frontale du tiroir extractible (4) derrière un dispositif de sécurité (1), l'ensemble d'engrenages (6) est connecté aux plaques lamellaires inférieures (5, 5A) qui sont connectées aux connecteurs d'énergie et de test ;
les plaques lamellaires (5, 5A) sont positionnées sur la face inférieure du tiroir extractible (4) pour l'armoire de CCM (16) et sont pourvues d'une pluralité de découpes (18) oblongues où des épingles de guidage (19) sont fixées et disposées dans la base (20) du tiroir extractible (4) qui est formé d'un seul tenant ;
lesdites plaques lamellaires (5, 5A) sont pourvues d'au moins deux languettes (14, 15) lamellaires qui sont des extensions orthogonales des plaques (5, 5A), orthogonales par rapport à leur plan et insérées dans des découpes de guidage (21);
les plaques lamellaires (5, 5A) sont pourvues d'une pluralité de découpes rectangulaires (22) alignées les unes avec les autres et conçues pour recevoir les dents d'engrenages placées dans l'ensemble d'engrenages (6), lesdites languettes lamellaires (14, 15) étant des points de connexion pour le connecteur de test et le connecteur d'énergie principal, respectivement ;
l'ensemble d'engrenages (6) présente, à l'intérieur, un élément pendulaire (6A) central flanqué d'au moins un ensemble d'engrenages (6b, 6c) conçus pour actionner le point de connexion (14) pour le connecteur de test et le point de connexion (15) pour le connecteur d'énergie principal ;
les éléments additionnels intérieurs de l'ensemble d'engrenages (6) sont constitués par des éléments de ressorts (6F) ;
l'ensemble d'engrenages (6) présente un boitier (6E) dans lequel ces éléments de ressorts (6F) sont positionnés ;
la face arrière de l'ensemble d'engrenages (6) présente une partie ergonomique (6H) et la face avant de l'ensemble d'engrenages (6) présente deux petites languettes de guidage (6D) parallèle l'une à l'autre, positionnées verticalement, renfermant entre elles un interstice de boitier pour une troisième languette appelée languette de guidage (23), placée dans la partie arrière d'un corps (7) du dispositif de sécurité (1), celui-ci étant positionné dans la partie arrière du dispositif de sécurité (1) et se fixant entre les languettes (6D) de l'ensemble d'engrenages (6) ; et
la face frontale de l'ensemble d'engrenages (6) présente un orifice central (24) qui abrite un commutateur (25) qui reçoit une languette de couplage (8) qui peut être connectée avec l'extrémité de la clé d'actionnement (2), permettant l'actionnement des connecteurs électriques, où ladite clé d'actionnement (2) est pourvue d'une saillance qui presse un bouton (6) couplé audit commutateur (25) qui, lorsqu'il est pressé par la saillance à l'extrémité de la clé d'actionnement (2), en conjonction avec la pression sur le dispositif de verrouillage (3), permet de tourner la clé d'actionnement (2) pour actionner le connecteur de test, et ensuite, en pressant une nouvelle fois le dispositif de verrouillage (3), permet de tourner la clé d'actionnement (2) pour actionner le connecteur d'énergie principal de l'équipement où le tiroir extractible (4) de l'armoire de CCM (16) est connecté.

2. Armoire de CCM (16) selon la revendication précédente, par laquelle
le dispositif de sécurité (1) est conçu pour actionner dans un premier mouvement de la clé d'actionnement (2) du tiroir extractible (4) pour actionner le connecteur de test, de manière concomitante avec la pression sur le dispositif de verrouillage (3) de sorte que les connecteurs principaux sont actionnés dans un second mouvement de la clé d'actionnement (2) des connecteurs électriques de même qu'un nouvel actionnement du dispositif de verrouillage (3).

3. Armoire de CCM (16) selon l'une quelconque des revendications précédentes, par laquelle le dispositif de sécurité (1) est conçu de sorte que les deux étapes, l'actionnement du connecteur de test et l'actionnement des connecteurs principaux, ont lieu avec la porte (13) du tiroir extractible (4) verrouillée dans la position fermée, de sorte que le déverrouillage de la porte (13) du tiroir extractible (4) a lieu dans l'actionnement du connecteur de test, et/ou que la porte (13) du tiroir extractible (4) se verrouille lorsque le connecteur d'énergie principal est actionné.

4. Armoire de CCM (16) selon l'une quelconque des revendications précédentes, par laquelle le dispositif de sécurité (1) est conçu pour accéder à l'intérieur du tiroir extractible (4) et pour qu'il soit possible de mettre en marche ou d'arrêter l'équipement connecté à l'armoire de CCM (16) pour effectuer une maintenance, entre autres, premièrement, la clé d'actionnement (2) est insérée, les connecteurs électriques sont positionnés dans le mode de test en tournant le connecteur de test, ce qui ne peut se produire uniquement avec la porte fermée.

5. Armoire de CCM (16) selon l'une quelconque des revendications précédentes, par laquelle le dispositif de sécurité (1) est conçu de sorte que
l'actionnement du connecteur d'énergie principal par la clé d'actionnement (2) n'a lieu que si le connecteur de test est connecté et si la porte (13) du tiroir extractible (4) est fermée, que,
lorsque la clé d'actionnement (2) retourne de la position d'actionnement du connecteur d'énergie principal vers la position de test, la porte est libérée, et/ou que
le retour à la position déconnectée a lieu en arrêtant le connecteur de test de la position de test, rendant cette opération possible uniquement et exclusivement si l'entrée est déconnectée.

6. Armoire de CCM (16) selon l'une quelconque des revendications précédentes, par laquelle
le dispositif de sécurité (1) est positionné dans la porte (13) du tiroir extractible (4) et est formé par un châssis (10) fixant le dispositif de sécurité (1), à l'opposé duquel est positionné un manchon d'entraînement (9), celui-ci, tour à tour, est fixé axialement dans le corps (7) du dispositif de sécurité (1), qui fournit une languette de guidage (23) et, fixés dans la partie arrière de ce corps (7), la languette de couplage (8) du tiroir (4) et le dispositif de sécurité (1) sont positionnés.

7. Armoire de CCM (16) selon l'une quelconque des revendications précédentes, par laquelle
le dispositif de sécurité (1) pour le verrouillage et l'actionnement des connecteurs électriques présente un degré de protection IP40 à IP55 et leurs formes de compartimentation jusqu'à (4B) en accord avec les exigences NR10, et/ou
le tiroir extractible (4) est conçu de sorte que le scellement et le verrouillage du tiroir extractible (4) est également possible par un cadenas ou d'autres moyens de verrouillage équivalents.

8. Armoire de CCM (16) selon l'une quelconque des revendications précédentes, par laquelle
le dispositif de verrouillage (3) présente un orifice (26) qui est un récepteur pour le cadenas de sécurité, et/ou que
le dispositif de sécurité (1) est conçu de sorte qu'en pressant le dispositif de verrouillage (3) et en effectuant la première rotation de la clé d'actionnement (2), la première petite plaque lamellaire (5A), en réponse à l'actionnement ou au verrouillage de la prise de test, est déplacée ; la porte (13) du tiroir extractible (4) reste fermée et verrouillée.
